**Europäisches Patentamt**

**European Patent Office**

**Office européen des brevets**

(11) Veröffentlichungsnummer: **0 304 901 B1**

(12) **EUROPÄISCHE PATENTSCHRIFT**

(45) Veröffentlichungstag der Patentschrift: **12.08.92**

(21) Anmeldenummer: **88113813.5**

(22) Anmeldetag: **24.08.88**

(51) Int. Cl.⁵: **H05K  3/22**

(54) **Anordnung zum Ändern und/oder Reparieren von Flachbaugruppen bei Bestückung mit SMD-Bausteinen.**

(30) Priorität: **28.08.87 DE 8711697 U**

(43) Veröffentlichungstag der Anmeldung:
**01.03.89 Patentblatt  89/09**

(45) Bekanntmachung des Hinweises auf die
Patenterteilung:
**12.08.92 Patentblatt  92/33**

(84) Benannte Vertragsstaaten:
**AT BE CH DE FR GB IT LI NL**

(56) Entgegenhaltungen:
**EP-A- 0 043 586**
**WO-A-84/00664**

(73) Patentinhaber: **Siemens Nixdorf Informations-**
**systeme AG**
**Otto-Hahn-Ring 6**
**W-8000 München 83(DE)**

(72) Erfinder: **Nagel, Günter**
**Herzlstrasse 18**
**W-8016 Heimstetten(DE)**

(74) Vertreter: **Fuchs, Franz-Josef, Dr.-Ing. et al**
**Postfach 22 13 17**
**W-8000 München 22(DE)**

## Beschreibung

Bei Fertigung von Multi-Layer-Leiterplatten (mit 2 bis z.B. 22 einzelnen Lagen) treten trotz aller Vorsichtsmaßnahmen immer wieder Fehler in Form von Unterbrechungen oder Einschnürungen der geätzten Leiterbahnen auf. Auch Fehler in den durchkontaktierten Bohrungen sind sporadisch zu verzeichnen. Bei Fehlern dieser Art ist ein Verwurf der Baugruppen aus Kosten-oder Termingründen in der Regel kaum möglich oder zweckmäßig, so daß eine einfache Reparaturmöglichkeit erforderlich ist. Nach der mit bedrahteten Bausteinen üblicherweise durchgeführten Reparaturmethode wurde in der Regel die unterbrochene Leitung durch einen Draht ersetzt, der auf die Lötflecken der Leiterplatte aufgelötet wurde.

Ferner kann es bei fertiggestellten Flachbaugruppen erforderlich sein, logische Änderungen in den auf den Leiterplatten realisierten Schaltungen schnell durchführen zu können. Dazu wird heute üblicherweise die nicht mehr benötigte geätzte Leiterbahn der Leiterplatte mechanisch getrennt und die neue Verbindung mit Hilfe eines Drahtes hergestellt.

Diese Verfahren sind aber bei Verwendung der im Zuge der fortschreitenden Miniaturisierung und Automatisierung in verstärktem Maße eingesetzten sogenannten SMD-Bausteine (Surface-Mounted-Device) nicht anwendbar, da nach Plazierung der Bausteine auf der Leiterplatte die jeweils verbleibende Restfläche auf den Lötflecken für das Auflöten von Änderungs- oder Reparaturdrähten zu gering ist. Bekannt geworden ist deshalb, bei Flat-Pack-Gehäusen das jeweils betroffene Beinchen abzulöten und hochzubiegen und den neuen Verbindungsdraht direkt an dem hochgebogenen Beinchen anzulöten. Diese Methode hat den Nachteil der schwierigen Mechanisierbarkeit und der meist sehr schwierigen Drahtführung auf der Bauteilseite der Flachbaugruppe.

Um diese Nachteile zu vermeiden hat man statt dessen die Anschlußflecken der SMD-Bauteile auf der Leiterplatte größer gemacht und trennbar ausgeführt. Diese Methode hat jedoch den Nachteil des größeren Platzbedarfes für das SMD-Bauteil und des Verlustes von Durchkontaktierungen auf der Leiterplatte.

Der Erfindung lag daher die Aufgabe zugrunde, eine Anordnung zu schaffen, mit deren Hilfe Änderungen und/oder Reparaturen an Leiterplatten auch dann durchgeführt werden können, wenn diese mit sogenannten SMD-oder ähnlichen Bausteinen bestückt sind.

Bei mit SMD-Bausteinen bestückten mehrlagigen Leiterplatten, bei denen die Signalverbindungen zu den Innenlagen über kurze Leiterbahnen und Durchkontaktierungen erfolgen, die unmittelbar unter den Bausteinen liegen, wird diese Aufgabe gelöst durch ein vorzugsweise deckungsgleiches, mit den unmittelbar unter den Bausteinen befindlichen Leiterbahnen fluchtendes zweites Leiterbahnmuster auf der den Bauteilen abgewandten Seite der Leiterplatte mit Durchkontaktierungen zwischen den jeweils entsprechenden Leiterbahnen auf den beiden Seiten der Leiterplatte.

Auf diese Weise lassen sich nicht nur die Nachteile der obengenannten bekannten Methoden vermeiden sondern es ergeben sich darüber hinaus noch die Vorteile, daß die Änderungs-und/oder Reparaturverdrahtung nur auf einer Seite der Leiterplatte ausgeführt werden kann und damit keine die beiden Seiten der Leiterplatte wechselnden Drähte erforderlich sind, und daß die Anschlußflecken für die Änderungs- und/oder Reparaturverdrahtung quasi im Schatten der Anschlußflecken für die SMD-Bausteine liegen und damit kein zusätzlicher Platz benötigt wird bzw. keine Durchkontaktierungsmöglichkeiten gesperrt sind. Ferner ergeben sich durch die erfindungsgemäße Anordnung gute Voraussetzungen für ein mechanisches Änderungsverfahren wie zum Beispiel eine sogenannte geschriebene Schaltung.

Weitere Einzelheiten der Erfindung ergeben sich aus der nachfolgenden Beschreibung anhand der Zeichnungen, in denen

FIG 1    einen Teil einer Leiterplatte mit einem SMD-Baustein

FIG 2    das erfindungsgemäße Leiterbahnmuster auf der anderen Seite der Leiterplatte und

FIG 3    eine erfindungsgemäße Anordnung im Schnitt zeigt.

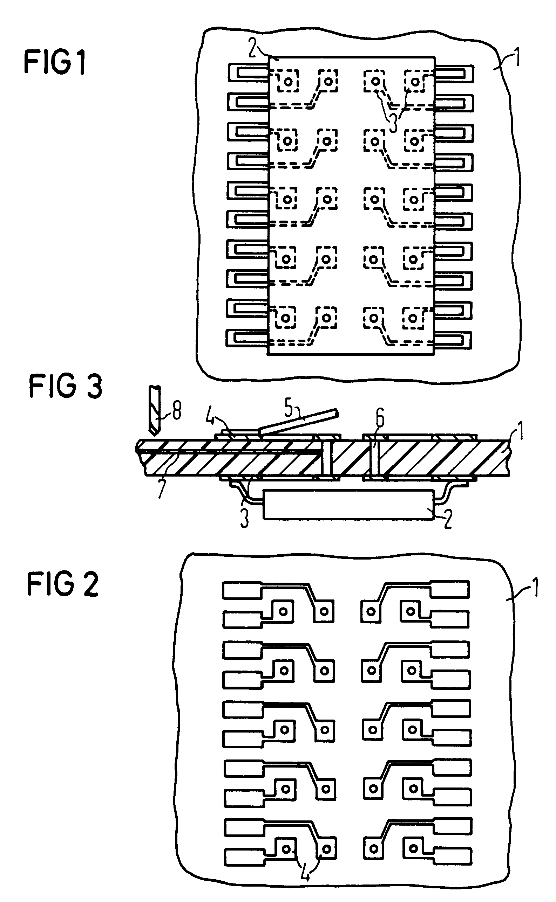

In FIG 1 ist ein Teil einer Leiterplatte 1 dargestellt, die einen sogenannten SMD-Baustein 2 trägt, der über eine Vielzahl von unmittelbar unter dem Baustein befindlichen Leiterbahnen 3 mit den Innenlagen der mehrlagigen Leiterplatte 1 verbunden ist. Wie aus FIG 1 und auch aus FIG 3 ersichtlich, ist der SMD-Baustein 2 in Bezug auf die Lötflecken der Leiterplatte so groß, daß ein Anlöten von Änderungs- und/oder Reparaturdrähten an den Lötflecken nicht möglich ist.

Erfindungsgemäß ist deshalb ein zweites Leiterbahnmuster 4 vorgesehen, wie es FIG 2 zeigt. Dieses ist vorzugsweise deckungsgleich mit dem unmittelbar unter den Bausteinen 2 befindlichen Leiterbahnmuster 3 und fluchtet mit diesem. Diese Leiterbahnmuster 4 befindet sich, wie FIG 3 erkennen läßt, auf der den Bauteilen 2 abgewandten Seite der Leiterplatte 1 und seine Leiterbahnen 4 sind mit den Leiterbahnen 3 auf der anderen Seite der Leiterplatte über Durchkontaktierungen 6 verbunden.

Wie FIG 3 erkennen läßt, ergibt sich auf diese Weise eine der Anzahl der für den Anschluß des Bausteines 2 dienenden Lötflecken entsprechende Anzahl von zweiten Lötflecken beziehungsweise Leiterbahnen 4, an die nunmehr in einfacher Weise Änderungs- und/oder Reparaturdrähte 5 angelötet werden können. In FIG 3 ist ferner angedeutet, wie im Falle einer Änderung der Schaltung eine im Inneren der Leiterplatte 1 befindliche Leiterbahn 7 mit Hilfe eines Bohrers 8 aufgetrennt und durch einen Änderungsdraht 5 ersetzt werden kann.

**Patentansprüche**

1. Anordnung zum Ändern und/oder Reparieren von Flachbaugruppen mit Bausteinen, die in bezug auf die Lötflecken der Leiterplatte so groß sind, daß ein Anlöten von Änderungs- und/oder Reparaturdrähten (5) an den Lötflecken nicht möglich ist, insbesondere für mit sogenannten SMD-Bausteinen (2) bestückte mehrlagige Leiterplatten (1), bei denen die Signalverbindungen zu den Innenlagen über kurze Leiterbahnen (3) und Durchkontaktierungen (6) erfolgen, die unmittelbar unter den Bausteinen (2) liegen, **gekennzeichnet durch** ein vorzugsweise deckungsgleiches, mit den unmittelbar unter den Bausteinen (2) befindlichen Leiterbahnen (3) fluchtendes zweites Leiterbahnmuster (4) auf der den Bauteilen (2) abgewandten Seite der Leiterplatte (1) mit Durchkontaktierungen (6) zwischen den jeweils entsprechenden Leiterbahnen (3, 4) auf den beiden Seiten der Leiterplatte (1).

**Claims**

1. Arrangement for modifying and/or repairing printed circuit boards with components which are so large in relation to the solder points of the printed circuit board that soldering on modifying and/or repair wires (5) to the solder points is not possible, in particular for multi-layer printed circuit boards (1) equipped with so-called surface-mounted components (2), in which circuit boards the signal connections to the inner layers are made via short conductor tracks (3) and throughplatings (6) which are located directly below the components (2), characterised by a preferably congruent second conductor track pattern (4), which is flush with the conductor tracks (3) located directly below the components (2), on the side of the printed circuit board (1) facing away from the components (2), with throughplatings (6) between the respectively corresponding conductor tracks (3, 4) on the two sides of the printed circuit board (1).

**Revendications**

1. Dispositif pour modifier/pour réparer des modules plats comportant des composants, qui sont d'une taille suffisamment importante par rapport aux spots de brasage de la plaquette à circuits imprimés, pour qu'un brasage de fils de modification et/ou de réparation (5) sur les plages de brasage ne soit pas possible, notamment pour des plaquettes à circuits imprimés et à couches multiples (1), qui sont équipées de ce qu'on appelle des composants SMD (2) et dans lesquelles des liaisons de transmission de signaux avec les couches intérieures s'effectuent par l'intermédiaire de courtes voies conductrices (1) et de courts contacts traversants (6), qui sont situés directement au-dessous des composants (2), caractérisé par un second modèle de voies conductrices (4), de préférence coïncidant, aligné avec les voies conductrices (3) situées directement au-dessous des modules (2), sur la face, tournée à l'opposé des modules (2), de la plaquette à circuits imprimés (1) et comportant des contacts traversants (6) situés entre les voies conductrices respectivement correspondantes (3,4), situées sur les deux faces de la plaquette à circuits imprimés (1).

FIG 1

FIG 3

FIG 2